(19) **Europäisches Patentamt / European Patent Office / Office européen des brevets**

(11) **EP 2 416 383 B1**

(12) **EUROPEAN PATENT SPECIFICATION**

(45) Date of publication and mention of the grant of the patent:
**30.07.2014 Bulletin 2014/31**

(21) Application number: **10761358.0**

(22) Date of filing: **26.03.2010**

(51) Int Cl.:
*H01L 31/048* (2014.01)    *B32B 27/08* (2006.01)
*B32B 27/36* (2006.01)    *B32B 27/16* (2006.01)
*B32B 27/32* (2006.01)    *B32B 27/28* (2006.01)
*B32B 15/09* (2006.01)    *B32B 15/20* (2006.01)
*B32B 7/12* (2006.01)

(86) International application number:
**PCT/JP2010/002164**

(87) International publication number:
**WO 2010/116650 (14.10.2010 Gazette 2010/41)**

(54) **PROTECTIVE SHEET FOR SOLAR CELL MODULE AND PRODUCTION METHOD THEREOF, AND SOLAR CELL MODULE**

SCHUTZFOLIE FÜR SOLARZELLENMODULE, VERFAHREN ZU IHRER HERSTELLUNG UND SOLARZELLENMODUL

FEUILLE DE PROTECTION POUR MODULE DE CELLULE SOLAIRE ET SON PROCÉDÉ DE FABRICATION, AINSI QUE MODULE DE CELLULE SOLAIRE

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **30.03.2009 JP 2009080882**

(43) Date of publication of application:
**08.02.2012 Bulletin 2012/06**

(73) Proprietor: **LINTEC Corporation**
**Tokyo 173-0001 (JP)**

(72) Inventors:
• **TAKANASHI, Yasunari**
  **Tokyo 173-0001 (JP)**
• **UTAGAWA, Tetsuyuki**
  **Tokyo 173-0001 (JP)**

(74) Representative: **Jansen, Cornelis Marinus et al**
**V.O.**
**Johan de Wittlaan 7**
**2517 JR Den Haag (NL)**

(56) References cited:
EP-A1- 1 921 684    WO-A1-2006/106844
JP-A- 2000 084 996    JP-A- 2000 114 565
JP-A- 2002 083 978    JP-A- 2007 150 084

• DATABASE WPI Week 200763 Thomson Scientific, London, GB; AN 2007-675281 XP002678044, -& JP 2007 150084 A (DAINIPPON PRINTING CO LTD) 14 June 2007 (2007-06-14)
• DATABASE WPI Week 200702 Thomson Scientific, London, GB; AN 2007-017084 XP002678045, -& WO 2006/106844 A1 (TOPPAN PRINTING CO LTD) 12 October 2006 (2006-10-12)
• DATABASE WPI Week 200232 Thomson Scientific, London, GB; AN 2002-270773 XP002678046, -& JP 2002 083978 A (SANYO ELECTRIC CO LTD) 22 March 2002 (2002-03-22)

**Description**

TECHNICAL FIELD

The present invention relates to a protective sheet for solar cell module to be used either as a front surface protective sheet or a back surface protective sheet in a solar cell module; a production method thereof; and a solar cell module that includes the protective sheet for solar cell module:

BACKGROUND ART

In response to concerns over the environmental issues, such as air pollution and global warming, solar cell modules that convert the energy of sunlight into the electrical energy have been attracting attention as a clean energy source capable of generating power without causing carbon dioxide emissions.

In general, a solar cell module is mainly constituted of a solar cell that performs photoelectric conversion, an encapsulant (sealing layer) formed of an electrical insulator that encapsulates the solar cell, a front surface protective sheet (front sheet) laminated on the front surface of the encapsulant, and a back surface protective sheet (back sheet) laminated on the back surface of the encapsulant. These solar cell modules are required to have certain levels of moisture resistance and weather resistance to be used outdoors as well as indoors for a prolonged period of time.

This solar cell module is mainly constituted of a solar cell composed of crystalline silicon, amorphous silicon or the like, an encapsulant (filling layer) formed of an electrical insulator that encapsulates the solar cell, a front surface protective sheet (front sheet) laminated on the front surface of the encapsulant, and a back surface protective sheet (back sheet) laminated on the back surface of the encapsulant.

As back surface protective sheets as described above, a back surface protective sheet in which a fluorine-based plastic film is provided on one or both sides of a layer made of metal or the like for preventing the permeation of water vapor has been disclosed (for example, refer to Patent Document 1). This back surface protective sheet is fused with an encapsulant composed of an ethylene-vinyl acetate (EVA) copolymer by a hot press method.

Prior Art Documents

[Patent Document]

Patent Document 1: Japanese Unexamined Patent Application, First Publication No. Hei 6-177412
Patent Document 2: JP 2007-150084 discloses a rear face protection sheet for a solar cell comprising a film of a hydrolysis-proof nature and a resin film laminated on the hydrolysis-proof film.
Patent Document 3: WO 2006/106844 discloses a back-surface protective sheet for solar cells that comprises an unstreched transparent polybutylene terephthalate film and, superposed thereon, a vapor-deposited gas-barrier film comprising an inorganic oxide, the vapor-deposited gas-barrier film being disposed on the solar cell element side.
Patent Document 4: JP 2002-083978 discloses a solar battery module having a protective film obtained by heat-treating a plastic film composed of a laminated body of an outer PVDF film and an inner PET film.
Patent Document 5: EP 1921684 discloses a solar cell module comprising a plurality of solar cells electrically connected with each other by a tab electrode, a filler for sealing the plurality of solar cells and a laminated resin film, arranged on at least one surface of the filler, in which a resin film consisting of PET resin, an adhesive film consisting of a copolymer of $\alpha$-olefin and an ethyleny unsaturated silane compound and a weather-resistant resin film consisting of PVDF resin are laminated successively from the side of the solar cells.

SUMMARY OF INVENTION

Technical Problem

However, when a conventional back surface protective sheet is used in a solar cell module, the back surface protective sheet is detached from an encapsulant, due to low adhesion to the encapsulant, thereby incorporating water vapor within the encapsulant. In order to solve this problem, it has been considered to provide a heat bondable layer on the back surface protective sheet and to fuse the back surface protective sheet to the above-mentioned encapsulant via the heat bondable layer. However, when this heat bondable layer is constructed from a sheet molded through a method, such as inflation molding, which involves a stretching process during molding, the sheet that constitutes the heat bondable layer shrinks due to the residual stress in the sheet. As a result, the solar cell module warps, which is undesirable. The warp of a solar cell module not only causes defects during the installation of the solar cell module, but may also break the solar cell module.

The present invention has been developed in light of the circumstances described above, and has an object of providing a protective sheet for solar cell module which exhibits, when used in a solar cell module, excellent adhesion to an encapsulant in the solar cell module and also suppresses the warp occurring in the solar cell module; a production method thereof; and a solar cell module that includes the protective sheet for solar cell module.

Means for Solving the Problem

A protective sheet for solar cell module according to the present invention is defined in claim 1.

The thermoplastic resin is preferably a polyolefin-based resin.

It is preferable that a metal sheet be laminated on a side of the substrate film which is opposite to the side where the heat bondable layer is laminated.

It is preferable that a deposition layer composed of an inorganic oxide be provided on at least one side of the substrate film.

It is preferable that a fluororesin layer be provided on at least one of the outermost layers of the protective sheet for solar cell module.

The fluororesin layer is preferably a coating film formed from a coating material including a fluorine-containing resin.

A solar cell module of the present invention is defined in claim 9.

The encapsulant is preferably composed of a polyolefin-based resin.

A method of producing a protective sheet for solar cell module according to the present invention is defined in claim 11.

Effects of Invention

In the protective sheet for solar cell module according to the present invention as defined in claim 1, the stress generated in the heat bondable layer per se due to the temperature change is small, and thus the action of stress on the substrate film where the heat bondable layer is laminated is also small. Therefore, even when the protective sheet for solar cell module according to the present invention is employed as a front sheet or a back sheet in the solar cell module, the warp that occurs in the solar cell module due to the temperature change during the production process can be suppressed.

Further, the heat bondable layer exhibits excellent adhesion to the substrate film. Moreover, since this heat bondable layer also exhibits excellent adhesion to the encapsulant of the solar cell module, the protective sheet for solar cell module according to the present invention hardly detaches from the solar cell module.

In the method of producing a protective sheet for solar cell module according to the present invention as defined in claim 11, the thermoplastic resin that forms the heat bondable layer laminated on the substrate film is not stretched, and thus no stress due to stretching acts on the heat bondable layer. As a result, there is no stress in the protective sheet for solar cell module which is caused by stretching of the thermoplastic resin that forms the heat bondable layer. Further, by employing extrusion molding, the heat bondable layer can be bonded to the substrate film only by extruding and laminating the melted thermoplastic resin on at least one side of the substrate film through extrusion molding. Therefore, there is no need to use an adhesive for bonding the heat bondable layer to the substrate film, and the thermoplastic resin can be bonded strongly to the substrate film.

BRIEF DESCRIPTION OF DRAWINGS

FIG. 1 is a schematic cross sectional view showing a first embodiment of a protective sheet for solar cell module according to the present invention.

FIG. 2 is a schematic cross sectional view showing a second embodiment of a protective sheet for solar cell module according to the present invention.

FIG 3 is a schematic cross sectional view showing a third embodiment of a protective sheet for solar cell module according to the present invention.

FIG. 4 is a schematic cross sectional view showing a fourth embodiment of a protective sheet for solar cell module according to the present invention.

FIG 5 is a schematic cross sectional view showing a fifth embodiment of a protective sheet for solar cell module according to the present invention.

FIG 6 is a schematic cross sectional view showing an embodiment of a solar cell module according to the present invention.

DESCRIPTION OF EMBODIMENTS

Embodiments of a protective sheet for solar cell module and a production method thereof, as well as a solar cell module according to the present invention will be described.

It should be noted that these embodiments are provided for the sake of detailed description in order to facilitate better understanding of the intent of the present invention, and do not limit the scope of the present invention in any way unless otherwise stated.

(1) First embodiment

(Protective sheet for solar cell module)

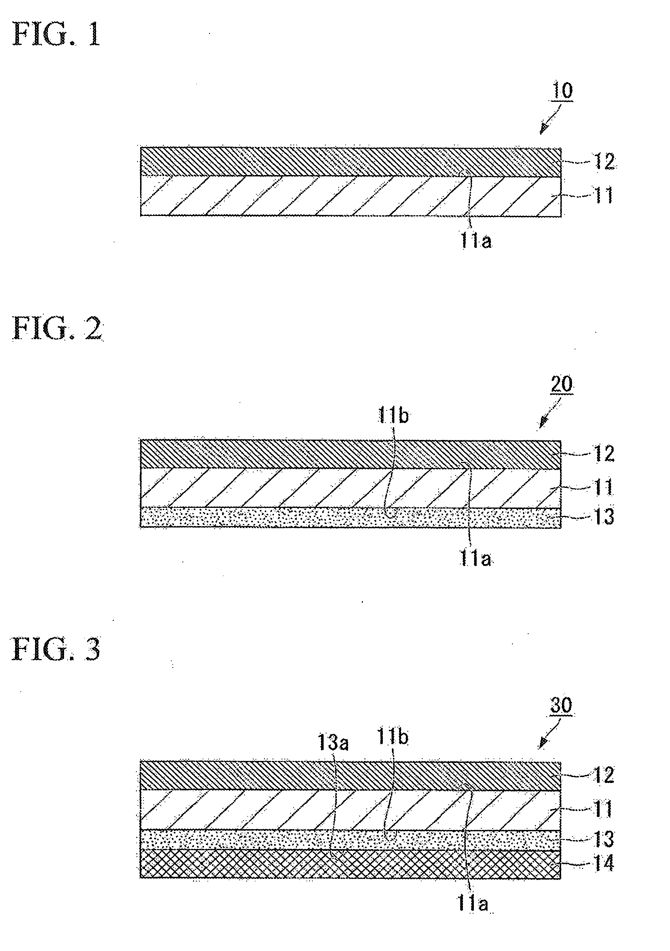

FIG. 1 is a schematic cross sectional view showing a first embodiment of a protective sheet for solar cell module according to the present invention.

A protective sheet for solar cell module 10 of the present embodiment is mainly constituted of a substrate film 11 and a heat bondable layer 12 laminated on one side 11a of the substrate film 11.

This protective sheet for solar cell module 10 can be employed as a front sheet or a back sheet in the solar cell module.

As the substrate film 11, a resin film or the like is used, provided that it is electrically insulating and the heat bondable layer 12 can be laminated thereon.

As a resin film used as the substrate film 11, those that are generally used as resin films in the protective sheets for solar cell module are selected. As such resin films, for example, resin films or sheets composed of resins including olefin-based resins such as polyethylene and polypropylene, ester-based resins such as polyethylene terephthalate (PET) and polyethylene naphthalate, amide-based resins such as nylon (product name), carbonate-based resins, styrene-based resins, acrylonitrile-based resins, vinyl chloride-based resins, vinyl acetal-based resins, vinyl butyral-based resins, and fluorine-based resins, may be used. Of these resin films, films composed of polyesters are preferred, and more specifically, PET films are suitable.

The thickness of the substrate film 11 is appropriately set based on the level of electrical insulation required for the solar cell module. For example, when the substrate film 11 is a resin film, the thickness thereof is preferably within a range from 10 $\mu$m to 300 $\mu$m. More specifically, when the substrate film 11 is a PET film, from the viewpoints of weight reduction and electrical insulation, the thickness thereof is preferably within a range from 10 $\mu$m to 300 $\mu$m, more preferably within a range from 20 $\mu$m to 250 $\mu$m, and most preferably within a range from 30 $\mu$m to 200 $\mu$m.

The heat bondable layer 12 is formed from a thermoplastic resin, and serves as an adhesive layer to be used for bonding with an encapsulant that constitutes the solar cell module.

The heat bondability with respect to the heat bondable layer 12 is a property to develop bondability by a heat treatment. In the present invention, there are no particular limitations on the thermoplastic resin that constitutes the heat bondable layer 12, as long as it is a thermoplastic resin exhibiting heat bondability. The temperature of the heat treatment for developing bondability is preferably within a range from 50 to 200°C.

The heat bondable layer 12 is formed by extruding and laminating the melted thermoplastic resin on one side 11a of the substrate film 11 through extrusion molding, and exhibits a dimensional variation of not more than 0.3% before and after a heat treatment at 150°C for 30 minutes. If the dimensional variation of the heat bondable layer 12 before and after a heat treatment at 150°C for 30 minutes is not more than 0.3%, the size of the heat bondable layer 12 does not change greatly by the heat treatment for developing bondability after being laminated on the substrate film 11 or by the cooling thereafter. For this reason, the stress generated in the heat bondable layer 12 per se due to the temperature change is small, and thus the action of stress on the substrate film 11 where the heat bondable layer 12 is laminated is also small. As a result, the level of bondability to the substrate film 11 increases, and the warp that occurs in the protective sheet for solar cell module 10 due to the temperature change can be suppressed. Further, even when the protective sheet for solar cell module 10 is employed as a front sheet or a back sheet in the solar cell module, the warp that occurs in the solar cell module due to the temperature change can be suppressed.

As a thermoplastic resin that constitutes the heat bondable layer 12, polyolefin-based resins are used favorably.

Examples of the polyolefin-based resins include polyethylene resins such as low-density polyethylenes (LDPE, having a density equal to or more than 0.910 g/cm$^3$ and less than 0.930 g/cm$^3$), medium-density polyethylenes (MDPE, having a density equal to or more than 0.930 g/cm$^3$ and less than 0.942 g/cm$^3$) and high-density polyethylenes (HDPE, having a density equal to or more than 0.942 g/cm$^3$); polypropylene (PP); olefin-based elastomers (TPO), cycloolefin-based resins, ethylene-vinyl acetate copolymers (EVA), ethylene-vinyl acetate-maleic anhydride copolymers, ethylene-(meth)acrylic acid copolymers, and ethylene-(meth)acrylate-maleic anhydride copolymers.

The thickness of the heat bondable layer 12 is not particularly limited as long as it does not impair the effects of the present invention, and is appropriately adjusted in accordance with the type of the heat bondable layer 12. The thickness of the heat bondable layer 12 is, for example, preferably within a range from 1 $\mu$m to 200 $\mu$m, and from the viewpoints of weight reduction, electrical insulation and the like, more preferably within a range from 10 $\mu$m to 200 $\mu$m, still more preferably within a range from 50 $\mu$m to 150 $\mu$m, and most preferably within a range from 80 $\mu$m to 120 $\mu$m.

The protective sheet for solar cell module 10 is a protective sheet for solar cell module including the substrate film 11 and the heat bondable layer 12 laminated on one side 11a of the substrate film 11, wherein the heat bondable layer 12 is formed from a thermoplastic resin, exhibits a dimensional variation of not more than 0.3% before and after a heat treatment at 150°C for 30 minutes and serves as an adhesive layer to be used for bonding with an encapsulant that constitutes the solar cell module. For this reason, the stress generated in the heat bondable layer 12 per se due to the temperature change is small, and thus the action of stress on the substrate film 11 where the heat bondable layer 12 is laminated is also small. Therefore, even when the protective sheet for solar cell module 10 is employed as a front sheet or a back sheet in the solar cell module, the warp that occurs in the solar cell module due to the temperature change during the production process can be suppressed. Further, the protective sheet for solar cell module 10 exhibits improved adhesion to the solar cell module, and hardly detaches from the solar cell module.

It should be noted that although the protective sheet for solar cell module 10 in which the heat bondable layer 12 is laminated on one side 11a of the substrate film 11 has been described as an example in the present embodiment, the protective sheet for solar cell module according to the present invention is not limited thereto. With respect to the protective sheet for solar cell module according to the present invention, a heat bondable layer may also be laminated on the other side (the side opposite to "one side") of the substrate film.

(Method of producing protective sheet for solar cell module)

Next, a method of producing the protective sheet for solar cell module 10 will be described by referring to FIG 1.

In order to produce the protective sheet for solar cell module 10, through an extrusion molding using a T-die extruder or T-die film forming machine, a thermoplastic resin for forming a heat bondable layer is melted and kneaded, and the melted thermoplastic resin is then extruded and laminated on one side 11a of the substrate film 11 while moving the substrate film 11 at a constant speed, thereby forming the heat bondable layer 12 composed of the thermoplastic resin on one side 11a of the substrate film 11 to obtain the protective sheet for solar cell module 10.

The temperature for melting the thermoplastic resin is set to a degree so that the substrate film 11 does not shrink by the temperature (heat) of the melted thermoplastic resin, is preferably within a range from 80 to 350°C, and is more preferably within a range from 150 to 300°C.

Further, the discharged amount of the thermoplastic resin from the T-die extruder (or T-die film forming machine) is appropriately adjusted in accordance with the intended thickness of the heat bondable layer 12 and the traveling speed (moving rate) of the substrate film 11.

The substrate film 11 is moved (transported) in the longitudinal direction, for example, by a roll-to-roll system at a constant speed, and the moving rate thereof is appropriately adjusted in accordance with the discharged amount of the thermoplastic resin from the T-die extruder (or T-die film forming machine).

According to the extrusion molding process as described above, because the thermoplastic resin that forms the heat bondable layer 12 laminated on the substrate film 11 is not stretched, no stress due to stretching acts on the heat bondable layer 12. As a result, there is no stress in the protective sheet for solar cell module 10 which is caused by stretching of the thermoplastic resin that forms the heat bondable layer 12.

Further, according to the extrusion molding process as described above, the heat bondable layer 12 can be bonded to the substrate film 11 only by extruding the melted thermoplastic resin from the T-die extruder (or T-die film forming machine) and laminating on one side 11a of the substrate film 11. Therefore, there is no need to use an adhesive for bonding the heat bondable layer 12 to the substrate film 11, and the heat bondable layer 12 can be bonded strongly to the substrate film 11.

As described above, in the protective sheet for solar cell module 10, because not only the stress caused by stretching of the heat bondable layer 12 is absent, but also the stress due to the extrusion molding of the heat bondable layer 12 hardly remains, even when the protective sheet for solar cell module 10 is employed as a front sheet or a back sheet in the solar cell module, the warp that occurs in the solar cell module due to the temperature change during the production process can be suppressed. Further, the protective sheet for solar cell module 10 exhibits improved adhesion to the solar cell module, and hardly detaches from the solar cell module.

Further, in those cases where a sheet formed by a method, other than the extrusion molding process as described above, for example, an inflation molding process is employed in the heat bondable layer 12, it is necessary to use an adhesive since the heat bondable layer 12 cannot be laminated directly onto the substrate film. Furthermore, in the sheet formed through inflation molding, the residual stress during film formation is present, and the stress due to the temperature change (namely, heat shrinkage) during the production process occurs in the heat bondable layer 12.

As described above, in those cases where a sheet formed by inflation molding is employed in a heat bondable layer, because the residual stress of heat bondable layer during film formation is present in the protective sheet for solar cell module, when the protective sheet for solar cell module is employed as a front sheet or a back sheet in the solar cell module, warp occurs in the solar cell module due to the temperature change during the production process.

(2) Second embodiment

FIG. 2 is a schematic cross sectional view showing a second embodiment of a protective sheet for solar cell module according to the present invention.

In FIG. 2, the same components as those in the protective sheet for solar cell module 10 shown in FIG. 1 will be given the same reference numerals, and the explanations thereof will be omitted here.

A protective sheet for solar cell module 20 of the present embodiment is employed, like the protective sheet of the first embodiment, as a front sheet or a back sheet in the solar cell module.

In the protective sheet for solar cell module 20, a deposition layer 13 is further provided in addition to the structure of the protective sheet for solar cell module 10 in the first embodiment.

In the present embodiment, the substrate film 11 and the heat bondable layer 12 have the same configurations as those in the first embodiment.

The deposition layer 13 is laminated, on the substrate film 11, on a side (hereafter, referred to as "the other side") 11b which is opposite to the side where the heat bondable layer 12 is provided.

The deposition layer 13 is constituted of inorganic materials such as metals, metalloids, and their oxides, nitrides, oxynitrides and silicides, and they are not particularly limited as long as the layer is formed through the deposition on the substrate film 11.

As the deposition method for forming the deposition layer 13, for example, chemical vapor deposition methods such as plasma enhanced chemical vapor deposition methods, thermal chemical vapor deposition methods and photochemical vapor deposition methods, or physical vapor deposition methods such as vacuum deposition methods, sputtering methods and ion plating methods are used. Of these methods, sputtering methods are preferred when operability or controllability of the layer thickness is taken into consideration.

This deposition layer 13 serves as a moisture-proof layer having water vapor barrier properties. Further, the weather resistance of the solar cell module can be improved by adopting the deposition layer 13 in the solar cell module.

As a metal, for example, metals such as aluminum (Al), magnesium (Mg), calcium (Ca), potassium (K), tin (Sn), sodium (Na), titanium (Ti), lead (Pb), zirconium (Zr) and yttrium (Y) are used.

As a metalloid, for example, metalloids such as silicon (Si) and boron (B) are used.

Examples of oxides, nitrides and oxynitrides of these metals and metalloids include aluminum oxide, tin oxide, silicon oxide, silicon nitride, silicon oxynitride and aluminum oxynitride.

The deposition layer 13 may be composed of one type of inorganic material or may be composed of several types of inorganic materials.

In those cases where the deposition layer 13 is composed of several types of inorganic materials, the deposition layer may have a lamination structure in which layers composed of each inorganic material are sequentially deposited, or the deposition layer may be a layer in which several types of inorganic materials are deposited at the same time.

The thickness of the deposition layer 13 is appropriately set in consideration of the water vapor barrier properties, and is changed depending on the type of inorganic material used, the deposition density, or the like. The thickness of the deposition layer 13 is preferably within a range from 5 nm to 200 nm, and more preferably within a range from 10 nm to 100 nm.

According to the protective sheet for solar cell module 20, by providing the deposition layer 13 to the substrate film 11 in addition to the protective sheet for solar cell module 10 of the first embodiment, the moisture-proof properties and the weather resistance can be improved, in addition to the effects achieved by the protective sheet for solar cell module 10.

Further, although the protective sheet for solar cell module 20 in which the deposition layer 13 is provided on the other side 11b of the substrate film 11 has been described as an example in the present embodiment, the protective sheet for solar cell module according to the present invention is not limited thereto. With respect to the protective sheet for solar cell module according to the present invention, a deposition layer may be provided on both sides (i.e., on one side as well as on the other side) of the substrate film.

(3) Third embodiment

FIG. 3 is a schematic cross sectional view showing a third embodiment of a protective sheet for solar cell module according to the present invention.

In FIG. 3, the same components as those in the protective sheet for solar cell module 10 shown in FIG. 1 and those in the protective sheet for solar cell module 20 shown in FIG. 2 will be given the same reference numerals, and the explanations thereof will be omitted here.

A protective sheet for solar cell module 30 of the present embodiment is employed, like the protective sheets of the first and second embodiments, as a front sheet or a back sheet in the solar cell module.

In the protective sheet for solar cell module 30, a fluororesin layer 14 is further provided in addition to the structure of the protective sheet for solar cell module 20 in the second embodiment.

In the present embodiment, the substrate film 11 and the heat bondable layer 12 have the same configurations as those in the first embodiment, and the deposition layer 13 has the same configurations as those in the second embodiment.

The fluororesin layer 14 is laminated, on the deposition layer 13, on a side (hereafter, referred to as "one side") 13a which is opposite to the side where the substrate film 11 comes into contact. The fluororesin layer 14 is provided so as to become a cured layer.

The thickness of the fluororesin layer 14 is set by taking the weather resistance, chemical resistance, weight reduction or the like into consideration, and is preferably within a range from 5 $\mu$m to 50 $\mu$m, more preferably within a range from 10 $\mu$m to 30 $\mu$m.

The fluororesin layer 14 is not particularly limited as long as it is a layer containing fluorine. Examples of those for forming the layer containing fluorine include a sheet including a fluorine-containing resin, and a coating film prepared by applying a coating material that includes a fluorine-containing resin. Of these, a coating film prepared by applying a coating material that includes a fluorine-containing resin is preferred from the viewpoint of further reducing the thickness of the fluororesin layer 14, in order to reduce the weight of the protective sheet for solar cell module 30.

In those cases where the fluororesin layer 14 is a sheet including a fluorine-containing resin, the fluororesin layer 14 is laminated on the deposition layer 13 via an adhesive layer. The adhesive layer is constituted of an adhesive that exhibits adhesion to the deposition layer 13.

As the adhesive that constitutes this adhesive layer, polyacrylic adhesives, polyurethane-based adhesives, epoxy-based adhesives, polyester-based adhesives, polyester polyurethane-based adhesives and the like are used. These adhesives may be used individually, or two or more types thereof may be used in combination.

On the other hand, in those cases where the fluororesin layer 14 is a coating film prepared by applying a coating material that includes a fluorine-containing resin, the fluororesin layer 14 is usually laminated on the deposition layer 13, without providing an adhesive layer, by directly applying the coating material that includes fluorine-containing resin onto the deposition layer 13.

As a sheet including a fluorine-containing resin, for example, those resins that are mainly composed of polyvinyl fluoride (PVF), ethylene chlorotrifluoroethylene (ECTFE) or ethylene tetrafluoroethylene (ETFE) and processed into a sheet form are used.

As a resin mainly composed of PVF, for example, the "TEDLAR" series of products (trade name, manufactured by E.I.du Pont de Nemours and Company) are used.

As a resin mainly composed of ECTFE, for example, the "HALAR" series of products (trade name, manufactured by Solvay Solexis Inc.) are used.

As a resin mainly composed of ETFE, for example, the "FLUON" series of products (trade name, manufactured by Asahi Glass Co., Ltd.) are used.

There are no particular limitations on the coating materials that include a fluorine-containing resin, provided that they are prepared by being dissolved in a solvent or dispersed in water, and are also coatable.

As a fluorine-containing resin included in the coating material, a fluoroolefin-containing resin which is soluble in a solvent of coating material (either an organic solvent or water) and is also crosslinkable may be used, although the resin is not particularly limited as long as it is a resin containing fluorine and does not impair the effects of the present invention.

As a fluorine-containing resin included in the coating material, it is preferable to use a fluoroolefin resin having a curable functional group. As the fluoroolefin resin, copolymers composed of tetrafluoroethylene (TFE), isobutylene, vinylidene fluoride (VdF), hydroxybutyl vinyl ether and other monomers, and copolymers composed of TFE, VdF, hydroxybutyl vinyl ether and other monomers are used.

Specific examples of the fluoroolefin resin include polymers mainly composed of chlorotrifluoroethylene (CTFE) such as the "LUMIFLON" series of products (trade name, manufactured by Asahi Glass Co., Ltd.), the "CEFRAL COAT" series of products (trade name, manufactured by Central Glass Co., Ltd.) and the "FLUONATE" series of products (trade name, manufactured by DIC Corporation), polymers mainly composed of tetrafluoroethylene (TFE) such as the "ZEFFLE" series of products (trade name, manufactured by Daikin Industries, Ltd.), polymers having a fluoroalkyl group such as the "ZONYL" series of products (trade name, manufactured by E.I.du Pont de Nemours and Company) and the "UNIDYNE" series of products (trade name, manufactured by Daikin Industries, Ltd.), and polymers mainly composed of fluoroalkyl units.

Of these, from the viewpoints of the weather resistance, the pigment dispersibility and the like, polymers mainly composed of CTFE and polymers mainly composed of TFE are preferred, and the "LUMIFLON" series of products and the "ZEFFLE" series of products are most preferred.

The "LUMIFLON" series of products are noncrystalline resins that contain CTFE and several kinds of specific alkyl vinyl ethers and hydroxyalkyl vinyl ethers as major structural units. As in the case of these "LUMIFLON" series of products, resins including the monomer units of hydroxyalkyl vinyl ethers are preferred because they exhibit excellent levels of solvent solubility, crosslinking reactivity, substrate adhesion, pigment dispersibility, hardness and flexibility.

The "ZEFFLE" series of products are copolymers of TFE and olefinic hydrocarbons soluble in an organic solvent. Of the various possibilities, those containing olefinic hydrocarbons having a highly reactive hydroxyl group are preferred since they exhibit excellent levels of solvent solubility, crosslinking reactivity, substrate adhesion and pigment dispersibility.

As a copolymerizable monomer for forming the fluorine-containing resin included in the coating material, for example, vinyl esters of carboxylic acids such as vinyl acetate, vinyl propionate, butyl butyrate, vinyl isobutyrate, vinyl pivalate, vinyl caproate, vinyl versatate, vinyl laurate, vinyl stearate, vinyl cyclohexylcarboxylate and vinyl benzoate; alkyl vinyl ethers such as methyl vinyl ether, ethyl vinyl ether, butyl vinyl ether and cyclohexyl vinyl ether; and fluorine-containing monomers such as CTFE, vinyl fluoride (VF), VdF and fluorinated vinyl ether are used.

Furthermore, the fluorine-containing resin included in the coating material may be a resin composed of one or more types of monomers, or may be a terpolymer.

As a terpolymer, for example, the "Dyneon THV" series of products (trade name, manufactured by 3M Company) which are terpolymers composed of VdF, TFE and hexafluoropropylene are used. Such terpolymers are preferred because they can provide resins with advantageous properties exhibited by the respective monomers. For example, the "Dyneon THV" series of products are preferred because they can be produced at a relatively low temperature and can be bonded to elastomers and hydrocarbon-based plastics, and also exhibit excellent flexibility and optical transparency.

The coating material may contain a cross-linking agent, a catalyst and a solvent, in addition to the aforementioned fluorine-containing resin, and may further contain inorganic compounds such as pigments and fillers if necessary.

The solvents included in the coating material are not particularly limited as long as they do not impair the effects of the present invention, and, for example, solvents containing any one of, or two or more types of organic solvents selected from the group consisting of methyl ethyl ketone (MEK), cyclohexanone, acetone, methyl isobutyl ketone (MIBK), toluene, xylene, methanol, isopropanol, ethanol, heptane, ethyl acetate, isopropyl acetate, n-butyl acetate and n-butyl alcohol are suitably used.

Among such solvents, from the viewpoints of solubility of the components included in the coating material and the low residual level (low boiling point) thereof within the coating film, solvents containing any one of, or two or more types of organic solvents selected from amongst xylene, cyclohexanone, and MEK are particularly desirable.

The pigments and fillers included in the coating material are not particularly limited as long as they do not impair the effects of the present invention, and, for example, titanium dioxide, carbon black, perylene pigments, mica, polyamide powers, boron nitride, zinc oxide, aluminum oxide, silica and the like are used. More specifically, as the pigments and fillers, in order to provide durability, the product "Ti-Pure R105" (product name, manufactured by manufactured by E.I.du Pont de Nemours and Company) which is rutile-type titanium dioxide treated with silicon oxide, and the product "CAB-O-SIL TS 720" (product name, manufactured by Cabot Corporation) which is hydrophobic silica prepared by the surface treatment of dimethyl silicone to modify the hydroxyl group in the silica surface are suitably used.

The aforementioned coating film is preferably cured with a cross-linking agent in order to improve the weather resistance and abrasion resistance.

The cross-linking agent is not particularly limited as long as it does not impair the effects of the present invention, and metal chelates, silanes, isocyanates and melamines are suitably used. When assuming that the back sheet 20 is used outdoors for 30 years or longer, aliphatic isocyanates are preferred as cross-linking agents in view of the weather resistance.

Composition of the coating material is not particularly limited as long as it does not impair the effects of the present invention, and the coating material is prepared, for example, by mixing a fluorine-containing resin, a pigment, a cross-linking agent, a solvent and a catalyst

In terms of the compositional ratio of this composition, the content of the fluorine-containing resin is preferably within a range from 3 to 80% by weight, and more preferably from 25 to 50% by weight, the content of the pigment is preferably within a range from 5 to 60% by weight, and more preferably from 10 to 30% by weight, and the content of the solvent is preferably within a range from 20 to 80% by weight, and more preferably from 25 to 65% by weight, relative to 100% by weight of the coating material as a whole.

As a solvent, for example, a mixed solvent composed of MEK, xylene and cyclohexanone is used.

Further, as a catalyst, for example, dioctyltin dilaurate is used. This catalyst is used for promoting the cross-linking between fluorine-containing resins and isocyanate.

Known methods are employed as a method for applying the coating material onto the deposition layer 13. For example, the coating material may be applied to a desired thickness using a rod coater.

The drying temperature for the coating material applied onto the deposition layer 13 is not restricted, provided that the temperature does not impair the effects of the present invention, and is preferably within a range from 50 to 130°C from the viewpoint of reducing the adverse effects to the deposition layer 13 and the substrate film 11.

According to the protective sheet for solar cell module 30, by providing the fluororesin layer 14 in addition to the protective sheet for solar cell module 20 of the second embodiment, the weather resistance and the chemical resistance can be improved, in addition to the effects achieved by the protective sheet for solar cell module 20. Therefore, in order to improve the weather resistance and chemical resistance of the protective sheet for solar cell module 30, the fluororesin layer 14 is preferably provided on the outer surface of the deposition layer 13 (namely, one side 13a of the deposition layer 13) within the protective sheet for solar cell module 30.

(4) Fourth embodiment

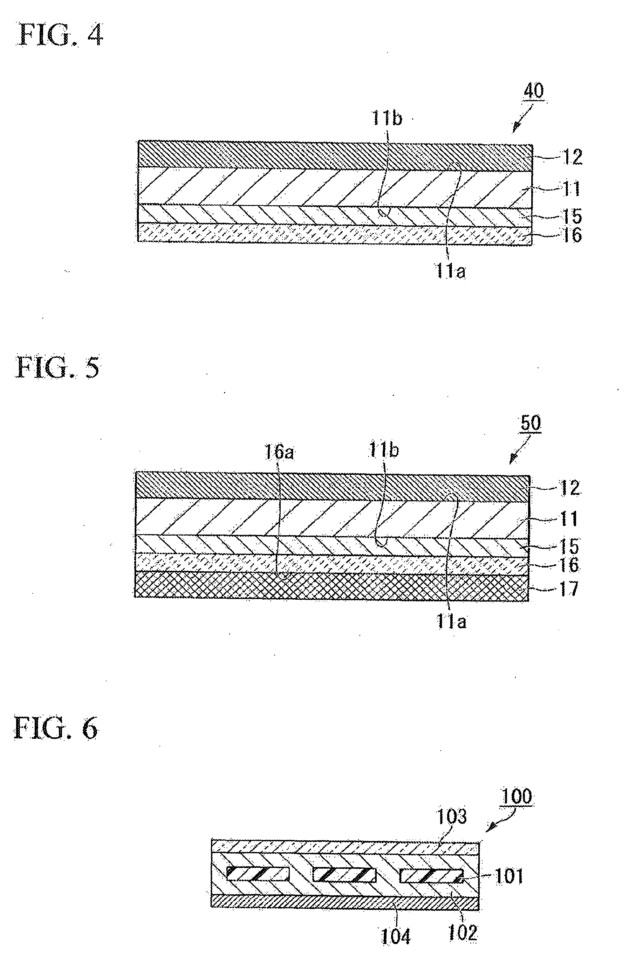

FIG. 4 is a schematic cross sectional view showing a fourth embodiment of a protective sheet for solar cell module according to the present invention.

In FIG. 4, the same components as those in the protective sheet for solar cell module 10 shown in FIG. 1 will be given the same reference numerals, and the explanations thereof will be omitted here.

A protective sheet for solar cell module 40 of the present embodiment is employed, like the protective sheet of the first embodiment, as a back sheet in the solar cell module.

In the protective sheet for solar cell module 40, a metal sheet 16 is further provided in addition to the structure of the protective sheet for solar cell module 10 in the first embodiment.

In the present embodiment, the substrate film 11 and the heat bondable layer 12 have the same configurations as those in the first embodiment.

The metal sheet 16 is laminated via an adhesive layer 15, on the substrate film 11, on a side (hereafter, referred to as "the other side") 11b which is opposite to the side where the heat bondable layer 12 is provided.

The adhesive layer 15 is constituted of an adhesive that exhibits adhesion to the substrate film 11.

As the adhesive that constitutes the adhesive layer 15, polyacrylic adhesives, polyurethane-based adhesives, epoxy-based adhesives, polyester-based adhesives, polyester polyurethane-based adhesives and the like are used. These adhesives may be used individually, or two or more types thereof may be used in combination.

As the metal sheet 16, for example, a sheet constituted of metals such as aluminum and aluminum-iron alloys is used.

Although the thickness of the metal sheet 16 is not particularly limited as long as the effects of the present invention are not impaired, it is preferably within a range from 5 $\mu$m to 100 $\mu$m, more preferably within a range from 10 $\mu$m to 30 $\mu$m from the viewpoints of low occurrence of pinholes, high mechanical strength and water vapor barrier properties, weight reduction and the like.

According to the protective sheet for solar cell module 40, by providing the metal sheet 16 to the substrate film 11 via the adhesive layer 15 in addition to the protective sheet for solar cell module 10 of the first embodiment, the water vapor barrier properties can be improved, in addition to the effects achieved by the protective sheet for solar cell module 10.

(5) Fifth embodiment

FIG. 5 is a schematic cross sectional view showing a fifth embodiment of a protective sheet for solar cell module according to the present invention.

In FIG. 5, the same components as those in the protective sheet for solar cell module 10 shown in FIG. 1 and those in the protective sheet for solar cell module 40 shown in FIG. 4 will be given the same reference numerals, and the explanations thereof will be omitted here.

A protective sheet for solar cell module 50 of the present embodiment is employed, like the protective sheet of the fourth embodiment, as a back sheet in the solar cell module.

In the protective sheet for solar cell module 50, a fluororesin layer 17 is further provided in addition to the structure of the protective sheet for solar cell module 40 in the fourth embodiment.

In the present embodiment, the substrate film 11 and the heat bondable layer 12 have the same configurations as those in the first embodiment, and the adhesive layer 15 and the metal sheet 16 have the same configurations as those in the fourth embodiment.

The fluororesin layer 17 is laminated, on the metal sheet 16, on a side (hereafter, referred to as "one side") 16a which is opposite to the side where the adhesive layer 15 comes into contact.

The fluororesin layer 17 has the same configurations as those of the fluororesin layer 14 described above.

The thickness of the fluororesin layer 17 is set by taking the weather resistance, chemical resistance, weight reduction or the like into consideration, and is preferably within a range from 5 $\mu$m to 50 $\mu$m, more preferably within a

range from 10 μm to 30 μm.

According to the protective sheet for solar cell module 50, by providing the fluororesin layer 17 in addition to the protective sheet for solar cell module 40 of the fourth embodiment, the weather resistance and the chemical resistance can be improved, in addition to the effects achieved by the protective sheet for solar cell module 40. Therefore, in order to improve the weather resistance and chemical resistance of the protective sheet for solar cell module 50, the fluororesin layer 17 is preferably provided on the outer surface of the metal sheet 16 (namely, one side 16a of the metal sheet 16) within the protective sheet for solar cell module 50.

(6) Sixth embodiment

FIG. 6 is a schematic cross sectional view showing an embodiment of a solar cell module according to the present invention.

A solar cell module 100 is mainly constituted of a solar cell 101 composed of crystalline silicon, amorphous silicon or the like, an encapsulant (sealing layer) 102 formed of an electrical insulator that encapsulates the solar cell 101, a front surface protective sheet (front sheet) 103 laminated on the front surface of the encapsulant 102, and a back surface protective sheet (back sheet) 104 laminated on the back surface of the encapsulant 102.

In the present embodiment, the solar cell module 100 is one in which the aforementioned protective sheets for solar cell module in the first to fifth embodiments are provided as the front sheet 103 or the back sheet 104.

In the present embodiment, a resin for constituting the encapsulant 102 is preferably a polyolefin-based resin.

As a polyolefin-based resin, polyethylenes such as low-density polyethylenes (LDPE, having a density equal to or more than 0.910 g/cm$^3$ and less than 0.930 g/cm$^3$), medium-density polyethylenes (MDPE, having a density equal to or more than 0.930 g/cm$^3$ and less than 0.942 g/cm$^3$) and high-density polyethylenes (HDPE, having a density equal to or more than 0.942 g/cm$^3$); polypropylenes (PP); olefin-based elastomers (TPO), cycloolefin-based resins, ethylene-vinyl acetate copolymers (EVA), ethylene-vinyl acetate-maleic anhydride copolymers, ethylene-(meth)acrylic acid copolymers, and ethylene-(meth)acrylate-maleic anhydride copolymers, and the like are used.

When configured as described above, the affinity between the heat bondable layer 12 and the encapsulant 102 in the protective sheets for solar cell module of the first to fifth embodiments increases, thereby increasing the bonding force between the heat bondable layer 12 and the encapsulant 102.

A solar cell module that achieves the aforementioned effects can be obtained by producing a solar cell module in which the protective sheets for solar cell module according to the first to fifth embodiments are employed as a front sheet or a back sheet in the solar cell module.

(7) Seventh embodiment

In the present embodiment, the solar cell module 100 is one in which the aforementioned protective sheets for solar cell module in the first to fifth embodiments are provided as the front sheet 103 and the back sheet 104.

Also in the present embodiment, a resin for constituting the encapsulant 102 is preferably a polyolefin-based resin.

A solar cell module exhibiting high sealing properties for solar cells can be obtained by producing a solar cell module in which the protective sheets for solar cell module according to the first to fifth embodiments are employed as a front sheet and a back sheet in the solar cell module.

Furthermore, a flexible solar cell module can be obtained by using a flexible substrate in a solar cell that constitutes the solar cell module, and providing the above-mentioned protective sheets for solar cell module according to the first to fifth embodiments as a front sheet and a back sheet. By making the solar cell modules flexible as described above, they can be produced in large quantities by a roll-to-roll system. Moreover, because the flexible solar cell modules can be fitted into objects with a wall surface having an arch shape or a parabolic shape, they can be installed in a dome-shaped construction, a sound-proof wall for an expressway, or the like.

The present invention will be described in more detail below using a series of examples and comparative examples, although the present invention is in no way limited by the following examples.

[Examples]

Example 1

An adhesive was applied on one side of a polyester film (product name: MELINEX 238, manufactured by Teijin DuPont Films Japan Ltd.) serving as a substrate film using a Mayer bar, and then dried at 80°C for 1 minute, thereby forming an adhesive layer having a thickness of 10 μm.

As an adhesive, a mixture prepared by mixing the adhesives A-515 (product name, manufactured by Mitsui Chemicals, Inc.) and A-3 (product name, manufactured by Mitsui Chemicals, Inc.) at a ratio of 9:1 (weight ratio) was used.

Subsequently, an aluminum foil (1N30 material) having a thickness of 20 $\mu$m was laminated on the outer surface of the adhesive layer (a side of the adhesive layer which was opposite to the side where the substrate film was brought into contact), thereby preparing a laminate constituted of the substrate film and the aluminum foil.

Then, the other side of the substrate film was subjected to a corona treatment.

Subsequently, using a T-die film forming machine, melted low-density polyethylene was extruded and laminated on the surface subjected to a corona treatment, and a heat bondable layer having a thickness of 50 $\mu$m and composed of a low-density polyethylene (product name: SUNTEC LDL-2270L, manufactured by Asahi Kasei Chemicals Corporation) was formed on that other side of the substrate film, thereby obtaining a protective sheet for solar cell module of Example 1.

In the formation of the heat bondable layer, the cylinder temperature and the T-die temperature in the T-die film forming machine were adjusted to 200°C and 320°C, respectively.

Example 2

A protective sheet for solar cell module of Example 2 was obtained in the same manner as in Example 1, with the exception that the thickness of the heat bondable layer composed of a low-density polyethylene was set to 100 $\mu$m.

Example 3

An adhesive was applied on one side of a polyester film (product name: MELINEX 238, manufactured by Teijin DuPont Films Japan Ltd.) serving as a substrate film using a Mayer bar, and then dried at 80°C for 1 minute, thereby forming an adhesive layer having a thickness of 10 $\mu$m.

As an adhesive, a mixture prepared by mixing the adhesives A-515 (product name, manufactured by Mitsui Chemicals, Inc.) and A-3 (product name, manufactured by Mitsui Chemicals, Inc.) at a ratio of 9:1 (weight ratio) was used.

Subsequently, an aluminum foil (1N30 material) having a thickness of 20 $\mu$m was laminated on the outer surface of the adhesive layer (a side of the adhesive layer which is opposite to the side where the substrate film was brought into contact), thereby preparing a laminate constituted of the substrate film and the aluminum foil.

Then, a coating material including a fluorine-containing resin was applied on the outer surface of the aluminum foil (a side of the aluminum foil which is opposite to the side where the adhesive layer was brought into contact) in the laminate constituted of the substrate film and the aluminum foil using a Meyer bar, and then dried at 130°C for 1 minute, thereby forming a fluororesin layer having a thickness of 15 $\mu$m.

As a coating material including a fluorine-containing resin, a mixture prepared by mixing 100 parts by weight of LUMIFLON LF-200 (product name, manufactured by Asahi Glass Co., Ltd.), 10 parts by weight of Sumidur N3300 (product name, manufactured by Sumika Bayer Urethane Co., Ltd.) and 30 parts by weight of Ti-Pure R105 (product name, manufactured by E.I.du Pont de Nemours & Company) was used.

Then, the other side of the substrate film was subjected to a corona treatment.

Subsequently, using a T-die film forming machine, melted low-density polyethylene was extruded and laminated on the surface subjected to a corona treatment, and a heat bondable layer having a thickness of 100 $\mu$m and composed of low-density polyethylene was formed on that other side of the substrate film, thereby obtaining a protective sheet for solar cell module of Example 3.

In the formation of the heat bondable layer, the cylinder temperature and the T-die temperature in the T-die film forming machine were adjusted to 200°C and 320°C, respectively.

Example 4

A protective sheet for solar cell module of Example 4 was obtained in the same manner as in Example 3, with the exception that a heat bondable layer was formed using an ethylene-vinyl acetate copolymer (ethylene: vinyl acetate = 91: 9; product name: Evaflex EVA-V5961, manufactured by Du Pont-Mitsui Polychemicals Co., Ltd.).

Comparative Example 1

As a heat bondable layer, an inflation film having a thickness of 100 $\mu$m was formed by inflation molding using the low-density polyethylene described in Example 1.

The same adhesive layer as described in Example 1 was formed on the back side of the substrate film in the laminate prepared in Example 1 and constituted of the substrate film and the aluminum foil.

A protective sheet for solar cell module of Comparative Example 1 was obtained by laminating the aforementioned inflation film onto the outer surface of the adhesive layer.

Comparative Example 2

A protective sheet for solar cell module of Comparative Example 2 was obtained in the same manner as in Comparative Example 1, with the exception that an ethylene-vinyl acetate copolymer (ethylene: vinyl acetate = 91: 9; product name: Evaflex EVA-V5961, manufactured by Du Pont-Mitsui Polychemicals Co., Ltd.) was used as a heat bondable layer.

Test Example 1

The dimensional variation of the protective sheets for solar cell module obtained in Examples 1 to 4 and Comparative Examples 1 and 2 was measured.
120 mm x 120 mm-sized test pieces were cut out from the protective sheets for solar cell module obtained in Examples 1 to 4 and Comparative Examples 1 and 2, and gauge marks were drawn, 10 mm inside from the respective edges, in the machine and cross machine directions to measure the initial gauge length.
Subsequently, the test pieces were placed and left to stand for 30 minutes in an oven kept at 150°C $\pm$ 2°C, and was then left to stand for 24 hours under the standard environment (i.e., a temperature of 23°C and a humidity of 50% RH).
Thereafter, the gauge length was measured at the same position as that prior to the test, and the dimensional variation of the test pieces before and after the heat treatment in the machine and cross machine directions was determined by the following equation (1).

$$\text{Dimensional variation (\%)} = |(L_1 - L_0)/ L_0| \times 100 \qquad (1)$$

It should be noted that in the above equation (1), $L_0$ denotes the initial gauge length (mm) of test piece, and $L_1$ denotes the gauge length (mm) of test piece after heating.
The results are shown in Table 1.

Test Example 2

The degree of warp of glass substrates on which one of the protective sheets for solar cell module obtained in Examples 1 to 4 and Comparative Examples 1 and 2 was laminated was measured.
Test pieces were prepared by cutting the protective sheets obtained in Examples 1 to 4 and Comparative Examples 1 and 2 into 250 mm x 250 mm-sized pieces.
Subsequently, the test piece was mounted by making either the aluminum foil side or the fluororesin layer side downward, followed by superposition of two pieces of EVA film for encapsulants (product name: SC-4, manufactured by Mitsui Chemicals Fablo, Inc.) on the surface (outer surface) of a heat bondable layer, and a glass substrate having a size of 1 mm $\times$ 250 mm $\times$ 250 mm was further superimposed thereon.
Subsequently, a product prepared by superimposing the test piece, the EVA film for encapsulants and the glass substrate was subjected to a hot pressing process at 150°C $\pm$ 2°C and 1 atmosphere for 30 minutes, and was then left to stand for 24 hours under the standard environment (i.e., a temperature of 23°C and a humidity of 50% RH), thereby obtaining a laminated body constituted of the test piece, the EVA film for encapsulants and the glass substrate.
Thereafter, the degree of warp of glass substrates was measured by placing a ruler on top of the laminated body along the vertical direction or horizontal direction and measuring the gap between the ruler and the laminated body.
The results are shown in Table 1.

[Table 1]

| | | Formation method of heat bondable layer | Dimensional variation (%) of test piece before and after heating (machine direction/ cross machine direction) | Degree of warp of glass substrate (mm) |
|---|---|---|---|---|
| | Ex. 1 | Extrusion molding | 0.11/0.07 | 0.0 |
| | Ex. 2 | Extrusion molding | 0.16/0.07 | 0.2 |
| | Ex. 3 | Extrusion molding | 0.18/0.08 | 0.3 |
| | Ex. 4 | Extrusion molding | 0.19/0.08 | 0.3 |

(continued)

| | Formation method of heat bondable layer | Dimensional variation (%) of test piece before and after heating (machine direction/ cross machine direction) | Degree of warp of glass substrate (mm) |
|---|---|---|---|
| Comp. Ex. 1 | Inflation molding | 0.80/0.35 | 4.5 |
| Comp. Ex. 2 | Inflation molding | 0.85/0.40 | 4.8 |

From the results shown in Table 1, it became clear that the degree of warp of glass substrates on which one of the protective sheets for solar cell module obtained in Examples 1 to 4 was laminated fell within a range free from problems.

INDUSTRIAL APPLICABILITY

The present invention provides a protective sheet for solar cell module to be used either as a front surface protective sheet or a back surface protective sheet in a solar cell module; a production method thereof; and a solar cell module that includes the protective sheet for solar cell module, and is thus industrially useful.

[Explanation of letters or numerals]

10, 20, 30, 40, 50:   Protective sheet for solar cell module
11:   Substrate film
12:   Heat bondable layer
13:   Deposition layer
14:   Fluororesin layer
15:   Adhesive layer
16:   Metal sheet
17:   Fluororesin layer
100:   Solar cell module
101:   Solar cell
102:   Encapsulant
103:   Front surface protective sheet (front sheet)
104:   Back surface protective sheet (back sheet)

**Claims**

1.   A protective sheet for solar cell module comprising:

a substrate film; and
a heat bondable layer laminated on at least one side of the substrate film,
wherein the heat bondable layer is formed from a thermoplastic resin,
and
serves as an adhesive layer to be used for bonding with an encapsulant that constitutes part of the solar cell module,
wherein the protective sheet for solar cell module exhibits a dimensional variation before and after heating of not more than 0.3% in the machine and cross machine directions before and after a heat treatment at 150°C for 30 minutes,
wherein the protective sheet for solar cell module is obtainable by melting and kneading a thermoplastic resin through extrusion molding,
extruding and laminating the melted thermoplastic resin on at least one side of the substrate film which is moving at a predetermined speed, and

forming the heat bondable layer composed of the thermoplastic resin on at least one side of the substrate film.

2. The protective sheet for solar cell module according to Claim 1, wherein the thermoplastic resin is a polyolefin-based resin.

3. The protective sheet for solar cell module according to Claim 1,
wherein a metal sheet is laminated on a side of the substrate film which is opposite to the side where the heat bondable layer is laminated.

4. The protective sheet for solar cell module according to Claim 1,
wherein a deposition layer composed of an inorganic oxide is provided on at least one side of the substrate film.

5. The protective sheet for solar cell module according to Claim 3, wherein a fluororesin layer is provided on an outermost layer of a side which is opposite to the side where the heat bondable layer is provided on the substrate film.

6. The protective sheet for solar cell module according to Claim 4, wherein a fluororesin layer is provided on an outermost layer of a side which is opposite to the side where the heat bondable layer is provided on the substrate film.

7. The protective sheet for solar cell module according to Claim 5,
wherein the fluororesin layer is a coating film formed from a coating material that includes a fluorine-containing resin.

8. The protective sheet for solar cell module according to Claim 6,
wherein the fluororesin layer is a coating film formed from a coating material that includes a fluorine-containing resin.

9. A solar cell module comprising:

   a solar cell;
   an encapsulant for encapsulating the solar cell; and
   a protective sheet laminated on the encapsulant,
   wherein the protective sheet is constituted of the protective sheet for solar cell module according to any one of Claims 1 to 8, and
   the protective sheet is laminated on the encapsulant via the heat bondable layer.

10. The solar cell module according to Claim 1, wherein the encapsulant is composed of a polyolefin-based resin.

11. A method of producing a protective sheet for solar cell module which includes a substrate film and a heat bondable layer laminated on at least one side of the substrate film, wherein the heat bondable layer is formed from a thermoplastic resin, and serves as an adhesive layer to be used for bonding with an encapsulant that constitutes part of the solar cell module, wherein the protective sheet for solar cell module exhibits a dimensional variation before and after heating of not more than 0.3% in the machine and cross machine directions before and after a heat treatment at 150°C for 30 minutes,
the method comprising:

   melting and kneading of the thermoplastic resin through extrusion molding,
   extruding and laminating the melted thermoplastic resin on at least one side of the substrate film which is moving at a predetermined speed, and
   forming the heat bondable layer composed of the thermoplastic resin on at least one side of the substrate film.


**Patentansprüche**

1. Schutzfolie für ein Solarzellenmodul, umfassend:

   einen Substratfilm; und
   eine hitzeverbindbare Schicht, die auf mindestens eine Seite des Substratfilms laminiert ist,
   wobei die hitzeverbindbare Schicht aus einem Thermoplastharz ausgebildet ist,
   und
   als eine Klebeschicht dient, die zum Verbinden mit einem Einkapselungsmaterial zu verwenden ist, das einen Teil des Solarzellenmoduls darstellt,
wobei die Schutzschicht für ein Solarzellenmodul eine Abmessungsvariation vor und nach dem Erhitzen von nicht mehr als 0,3% in der Maschinenrichtung und in der Maschinen-Querrichtung vor und nach der Hitzebehandlung bei 150°C für 30 Minuten aufweist,
wobei die Schutzschicht für ein Solarzellenmodul erhältlich ist durch
Schmelzen und Kneten eines Thermoplastharzes durch Strangpressen,
Extrudieren und Laminieren des geschmolzenen Thermoplastharzes auf mindestens einer Seite des Substratfilms, der sich mit einer vorbestimmten Geschwindigkeit bewegt, und
Ausbilden der aus dem Thermoplastharz zusammengesetzten hitzeverbindbaren Schicht auf mindestens einer Seite des Substratfilms.

2. Schutzfolie für ein Solarzellenmodul gemäß Anspruch 1, wobei das Thermoplastharz ein auf Polyolefin basiertes Harz ist.

3. Schutzfolie für ein Solarzellenmodul gemäß Anspruch 1,
wobei eine Metallfolie auf eine Seite des Substratfilms laminiert ist, die der Seite gegenüber liegt, auf die die hitzeverbindbare Schicht laminiert ist.

4. Schutzfolie für ein Solarzellenmodul gemäß Anspruch 1,
wobei eine Abscheidungsschicht, die aus einem anorganischen Oxid gebildet ist, auf mindestens einer Seite des Substratfilms vorgesehen ist.

5. Schutzfolie für ein Solarzellenmodul gemäß Anspruch 3, wobei eine Fluorharzschicht auf einer äußersten Schicht einer Seite vorgesehen ist, die der Seite gegenüber liegt, auf der die hitzeverbindbare Schicht auf dem Substratfilm vorgesehen ist.

6. Schutzfolie für ein Solarzellenmodul gemäß Anspruch 4, wobei eine Fluorharzschicht auf einer äußersten Schicht einer Seite vorgesehen ist, die der Seite gegenüber liegt, auf der die hitzeverbindbare Schicht auf dem Substratfilm vorgesehen ist.

7. Schutzfolie für ein Solarzellenmodul gemäß Anspruch 5,
wobei die Fluorharzschicht ein Beschichtungsfilm ist, der aus einem Beschichtungsmaterial ausgebildet ist, das ein Fluor enthaltendes Harz beinhaltet.

8. Schutzfolie für ein Solarzellenmodul gemäß Anspruch 6,
wobei die Fluorharzschicht ein Beschichtungsfilm ist, der aus einem Beschichtungsmaterial ausgebildet ist, das ein Fluor enthaltendes Harz beinhaltet.

9. Solarzellenmodul, umfassend:

eine Solarzelle;
ein Einkapselungsmaterial zum Einkapseln der Solarzelle; und
eine Schutzfolie, die auf das Einkapselungsmaterial laminiert ist,
wobei die Schutzfolie aus der Schutzfolie für ein Solarzellenmodul gemäß einem der Ansprüche 1 bis 8 besteht, und
die Schutzschicht über die hitzeverbindbare Schicht auf das Einkapselungsmaterial laminiert ist.

10. Solarzellenmodul gemäß Anspruch 1, wobei das Einkapselungsmaterial aus einem auf Polyolefin basierten Harz besteht.

11. Verfahren zum Herstellen einer Schutzfolie für ein Solarzellenmodul, das einen Substratfilm und eine hitzeverbindbare Schicht umfasst, die auf mindestens eine Seite des Substratfilms laminiert ist, wobei die hitzeverbindbare Schicht aus Thermoplastharz ausgebildet ist und als eine Klebeschicht dient, die zum Verbinden mit einem Einkapselungsmaterial zu verwenden ist, das einen Teil des Solarzellenmoduls darstellt, wobei die Schutzfolie für ein Solarzellenmodul eine Abmessungsvariation vor und nach dem Erhitzen von nicht mehr als 0,3% in der Maschinenrichtung und in der Maschinen-Querrichtung vor und nach der Hitzebehandlung bei 150°C für 30 Minuten aufweist,
wobei das Verfahren umfasst:

Schmelzen und Kneten eines Thermoplastharzes durch Strangpressen,
Extrudieren und Laminieren des geschmolzenen Thermoplastharzes auf mindestens einer Seite des Substratfilms, der sich mit einer vorbestimmten Geschwindigkeit bewegt, und
Ausbilden der aus dem Thermoplastharz bestehenden hitzeverbindbaren Schicht auf mindestens einer Seite des Substratfilms.

**Revendications**

1. Feuille de protection pour module de cellule solaire qui comprend :

   un film de substrat ; et
   une couche à liaison thermique laminée sur au moins un côté du film de substrat, la couche à liaison thermique étant formée en résine thermoplastique, et servant de couche adhésive utilisée pour la liaison avec un encapsulant qui fait partie du module de cellule solaire,
   la feuille de protection pour module de cellule solaire présentant une variation dimensionnelle avant et après un chauffage de moins de 0,3% dans le sens machine et dans le sens inverse avant et après un traitement thermique à 150°C pendant 30 minutes,
   la feuille de protection pour module de cellule solaire pouvant être obtenue en fondant et en pétrissant une résine thermoplastique par moulage par extrusion,
   en extrudant et en laminant la résine thermoplastique fondue sur au moins un côté du film de substrat qui se déplace à une vitesse prédéterminée, et
   en formant la couche à liaison thermique composée de la résine thermoplastique sur au moins un côté du film de substrat.

2. Feuille de protection pour module de cellule solaire selon la revendication 1, dans laquelle la résine thermoplastique est une résine à base de polyoléfine.

3. Feuille de protection pour module de cellule solaire selon la revendication 1, dans laquelle une feuille de métal est laminée sur un côté du film de substrat qui est opposé au côté sur lequel est laminée la couche à liaison thermique.

4. Feuille de protection pour module de cellule solaire selon la revendication 1, dans laquelle une couche de dépôt composée d'un oxyde inorganique est prévue sur au moins un côté du film de substrat.

5. Feuille de protection pour module de cellule solaire selon la revendication 3, dans laquelle une couche de fluororésine est prévue sur une couche extérieure d'un côté qui est opposé au côté sur lequel la couche à liaison thermique est prévue sur le film de substrat.

6. Feuille de protection pour module de cellule solaire selon la revendication 4, dans laquelle une couche de fluororésine est prévue sur une couche extérieure d'un côté qui est opposé au côté sur lequel la couche à liaison thermique est prévue sur le film de substrat.

7. Feuille de protection pour module de cellule solaire selon la revendication 5, dans laquelle la couche de fluororésine est un film de revêtement formé en matériau de revêtement qui comprend une résine qui contient du fluor.

8. Feuille de protection pour module de cellule solaire selon la revendication 6, dans laquelle la couche de fluororésine est un film de revêtement formé en matériau de revêtement qui comprend une résine qui contient du fluor.

9. Module de cellule solaire qui comprend :

   une cellule solaire ;
   un encapsulant destiné à encapsuler la cellule solaire ; et
   une feuille de protection laminée sur l'encapsulant,
   la feuille de protection étant constituée de la feuille de protection pour module de cellule solaire selon l'une quelconque des revendications 1 à 8, et
   la feuille de protection étant laminée sur l'encapsulant via la couche à liaison thermique.

10. Feuille de protection pour module de cellule solaire selon la revendication 1, dans laquelle l'encapsulant est composé d'une résine à base de polyoléfine.

11. Procédé de fabrication d'une feuille de protection pour module de cellule solaire qui comprend un film de substrat et une couche à liaison thermique laminée sur au moins un côté du film de substrat, dans lequel la couche à liaison thermique est formée en résine thermoplastique, et sert de couche adhésive utilisée pour la liaison avec un encapsulant qui fait partie du module de cellule solaire, la feuille de protection pour module de cellule solaire présentant une variation dimensionnelle avant et après un chauffage de moins de 0,3% dans le sens machine et dans le sens inverse avant et après un traitement thermique à 150°C pendant 30 minutes,
le procédé comprenant :

la fusion et le pétrissage de la résine thermoplastique par moulage par extrusion, l'extrusion et le laminage de la résine thermoplastique fondue sur au moins un côté du film de substrat qui se déplace à une vitesse prédéterminée, et
la formation de la couche à liaison thermique composée de la résine thermoplastique sur au moins un côté du film de substrat.

FIG. 1

FIG. 2

FIG. 3

FIG. 4

FIG. 5

FIG. 6

**REFERENCES CITED IN THE DESCRIPTION**

**Patent documents cited in the description**

- JP HEI6177412 B
- JP 2007150084 A
- WO 2006106844 A
- JP 2002083978 A
- EP 1921684 A